# EUROPÄISCHE PATENTSCHRIFT

(11) **EP 3 378 108 B1**
(45) Veröffentlichungstag und Bekanntmachung des Hinweises auf die Patenterteilung: **25.08.2021**
(21) Anmeldenummer: 16795099.7
(22) Anmeldetag: 15.11.2016
(51) Int. Cl.: H01L 41/107, C01B 13/11

(54) **PIEZOELEKTRISCHER TRANSFORMATOR**
PIEZOELECTRIC TRANSFORMER
TRANSFORMATEUR PIÉZOÉLECTRIQUE

(30) Priorität: 20.11.2015 DE 102015120160
(43) Veröffentlichungstag der Anmeldung: 26.09.2018
(73) Patentinhaber: TDK Electronics AG, 81671 München (DE)
(72) Erfinder: WEILGUNI, Michael, 4232 Hagenberg (AT); PUFF, Markus, 8010 Graz (AT); KUDELA, Pavol, 8530 Deutschlandsberg (AT); DÖLLGAST, Bernhard, 8530 Deutschlandsberg (AT)
(74) Vertreter: Epping - Hermann - Fischer
(86) Internationale Anmeldenummer: PCT/EP2016/077719
(87) Internationale Veröffentlichungsnummer: WO 2017/085055

(56) Entgegenhaltungen:
- JP-A- H08 151 265
- JP-A- H10 223 938
- JP-A- 2003 297 295

## Beschreibung

Die vorliegende Erfindung betrifft einen piezoelektrischen Transformator. Der piezoelektrische Transformator kann zur Erzeugung von Plasma, insbesondere einem nichtthermischen Atmosphärendruck-Plasma, eingesetzt werden.

Bei bekannten quaderförmigen piezoelektrischen Transformatoren wurde beobachtet, dass es zu Plasmazündungen entlang der längsseitigen Kanten des Ausgangsbereichs kommt. Diese Plasmazündungen führen zu unerwünschten Rückkopplungen, bei denen mechanische Spannungen in einem piezoelektrischen Material des Ausgangsbereichs erzeugt werden, die zu Rissen in dem Material führen können. Dadurch kann die Lebensdauer des piezoelektrischen Transformators verkürzt werden.

JP 10-223938 A und JP 08-151265 A geben jeweils Beispiele für die geometrischen Abmessungen von piezoelektrischen Transformatoren an. Der in JP 10-223938 A beschriebene piezoelektrische Transformator ist insbesondere für den Einsatz in einem Backlight Inverter in einem LCD Bildschirm vorgesehen. JP 08-151265 A sieht vor, eine an einer Ausgangseite des Transformators erzeugte Hochspannung abzugriffen und an eine Kaltkathoden-Gasentladungsröhre anzulegen.

Aufgabe der vorliegenden Erfindung ist es daher, einen verbesserten piezoelektrischen Transformator anzugeben, der beispielsweise eine längere Lebensdauer aufweisen kann.

Diese Aufgabe wird durch ein Verfahren gemäß dem vorliegenden Anspruch 1 sowie ein durch ein medizinisches Gerät gemäß dem vorliegenden Anspruch 15 gelöst.

In dem erfindungsgemäßen Verfahren und dem erfindungsgemäßen medizinischen Gerät wird ein piezoelektrischer Transformator verwendet, der einen Eingangsbereich und einen Ausgangsbereich aufweist, wobei der Eingangsbereich dazu ausgestaltet ist, eine angelegte Wechselspannung in eine mechanische Schwingung zu wandeln, und wobei der Ausgangsbereich dazu ausgestaltet ist, eine mechanische Schwingung in eine elektrische Spannung zu wandeln. Ferner weist der piezoelektrische Transformator eine längste Kante und eine kürzeste Kante auf, wobei die längste Kante eine Länge aufweist, die maximal das Zwanzigfache der Länge der kürzesten Kante beträgt.

Das Verhältnis der Länge der längsten Kante zu der Länge der kürzesten Kante wird auch als Aspektverhältnis bezeichnet. Es konnte gezeigt werden, dass bei piezoelektrischen Transformatoren, die ein Aspektverhältnis von ≤ 20:1 aufweisen, unerwünschte Plasmazündungen entlang der längsseitigen Kante im Ausgangsbereich vermieden werden können. Dementsprechend kommt es bei diesen Transformatoren nicht zu erheblichen mechanischen Belastungen des piezoelektrischen Materials im Ausgangsbereich, sodass hier keine Risse entstehen und die Lebensdauer nicht verkürzt wird.

Der piezoelektrische Transformator kann beispielsweise ein Transformator vom Rosen-Typ sein. Der piezoelektrische Transformator kann ferner derart konstruiert sein, dass das Aspektverhältnis ≥ 2:1, vorzugsweise ≥ 5:1, ist.

Als Kanten können hierbei die Linien bezeichnet werden, an denen zwei Seitenflächen des piezoelektrischen Transformators aneinander stoßen.

Der piezoelektrische Transformator kann im Wesentlichen quaderförmig sein. Dabei können die Kanten des Transformators abgerundet sein. Insbesondere können die Kanten mit einem sehr geringen Radius abgerundet sein, der beispielsweise ≤ 0,5 mm beträgt.

Die längste Kante kann sich in einer Längsrichtung von einem Eingangsbereich hin zu einem Ausgangsbereich erstrecken. Die kürzeste Kante kann eine Kante einer ausgangsseitigen Stirnseite sein. Die ausgangsseitige Stirnseite ist eine Endfläche, die vom Eingangsbereich weg weist.

Wie oben beschrieben, weist der piezoelektrische Transformator mit einem Aspektverhältnis von ≤ 20:1 eine längere Lebensdauer auf, da es nicht zu erheblichen mechanischen Belastungen des Ausgangsbereiches kommt. Darüber hinaus weist dieser Transformator weitere Vorteile auf. Das bevorzugte Aspektverhältnis von ≤ 20:1 führt zu einer verbesserten Effizienz der Ozongenerierung. Insbesondere kann bei gleichbleibender Eingangsleistung pro Volumeneinheit des piezoelektrischen Transformators bei dem Aspektverhältnis von ≤ 20:1 mehr Ozon produziert werden. Die Verbesserung der Effizienz der Ozongenerierung ist begründet in einer Verbesserung der Anpassung der Ausgangsimpedanz des piezoelektrischen Transformators an die vom Plasma erzeugte Impedanz, welche sich bei dem Aspektverhältnis von ≤ 20:1 einstellt.

Erfindungsgemäß wird an einer Stirnseite des piezoelektrischen Transformators ein Plasma gezündet. Dabei handelt es sich bei dem Plasma vorzugsweise um nicht-thermisches Atmosphärendruck-Plasma.

Vorzugsweise weist die längste Kante eine Länge von weniger als 45 mm auf. Vorzugsweise weist die längste Kante eine Länge von weniger als 35 mm auf. Die längste Kante kann eine Mindestlänge von 10 mm aufweisen.

Eine solche verkürzte Bauform des piezoelektrischen Transformators weist zahlreiche Vorteile auf. Die zur Polung eines solchen piezoelektrischen Transformators erforderliche Polungsspannung hängt im Wesentlichen von der Länge des piezoelektrischen Transformators ab. Dementsprechend ist zur Polung eines Transformators, dessen längste Kante eine Länge von weniger als 45 mm, beziehungsweise von weniger als 35 mm, aufweist, nur eine geringe Spannung erforderlich. Dadurch wird das Herstellungsverfahren des jeweiligen piezoelektrischen Transformators vereinfacht.

Ferner hängt die Resonanzfrequenz des jeweiligen piezoelektrischen Transformators von der Länge der längsten Kante ab. Eine kurze Länge der längsten Kante ermöglicht es, piezoelektrische Transformatoren mit einer hohen Resonanzfrequenz zu fertigen. Beispielsweise kann durch eine längste Kante, die kürzer als 35 mm ist, eine Resonanzfrequenz von mehr als 100 kHz erreicht werden. Solche Resonanzfrequenzen sind insbesondere bei Plasmageneratoren, die in medizinischen Anwendungen eingesetzt werden, vorteilhaft.

Ferner führt eine höhere Resonanzfrequenz zu steileren Flanken der Ausgangsspannung, die wiederum positiv auf die Effizienz der Ozongenerierung wirken.

Auf einer ersten Seitenfläche des Eingangsbereichs kann eine erste Außenelektrode angeordnet sein. Auf einer zweiten Seitenfläche des Eingangsbereichs, die der ersten Seitenfläche gegenüberliegt, kann eine zweite Außenelektrode angeordnet sein. Der Eingangsbereich kann in einer Stapelrichtung übereinander gestapelte piezoelektrische Schichten und Elektroden aufweisen. Die Elektroden können in der Stapelrichtung abwechselnd entweder mit der ersten Außenelektrode oder mit der zweiten Außenelektrode kontaktiert sein. Der Ausgangsbereich kann eine monolithische piezoelektrische Schicht aufweisen. Das piezoelektrische Material der piezoelektrischen Schicht im Ausgangsbereich kann identisch sein zu dem piezoelektrischen Material der piezoelektrischen Schichten im Eingangsbereich.

Die längste Kante kann sich von dem Eingangsbereich zu dem Ausgangsbereich erstrecken. Die kürzeste Kante kann senkrecht zur längsten Kante sein.

Der piezoelektrische Transformator kann eine Resonanzfrequenz von mehr als 100 kHz aufweisen. Diese Frequenzen sind insbesondere für Anwendungen im medizinischen Bereich vorteilhaft.

Die längste Kante kann eine Länge aufweisen, die maximal das Fünfzehnfache der Länge der kürzesten Kante des piezoelektrischen Transformators beträgt. Dementsprechend kann sich ein Aspektverhältnis von ≤ 15:1 einstellen. Durch eine so kleine Wahl des Aspektverhältnisses kann sichergestellt werden, dass es nicht zu Plasmazündungen entlang der längsseitigen Kanten kommt. Auch die Effizienz der Ozongenerierung kann auf diese Weise weiter erhöht werden.

Die kürzeste Kante kann eine Länge zwischen 10 mm und 1 mm aufweisen. Vorzugsweise weist die kürzeste Kante eine Länge zwischen 5 mm und 2 mm auf. Die Länge der kürzesten Kante wird so gewählt, dass sich ein vorteilhaftes Aspektverhältnis von ≤ 20:1 einstellt.

Durch das Verhältnis der Länge der längsten Kante zu der Länge der kürzesten Kante können Plasmazündungen entlang der längsten Kante im Ausgangsbereich vermieden werden. Dementsprechend kann auf einen Isolierung, beispielsweise einen Schrumpfschlauch, der den Ausgangsbereich teilweise ummantelt, verzichtet werden. Der piezoelektrische Transformator kann somit im Ausgangsbereich frei von einer Isolierung sein. Der piezoelektrische Isolator kann insbesondere keinen Schrumpfschlauch aufweisen.

Durch das Verhältnis der Länge der längsten Kante zu der Länge der kürzesten Kante können mechanische Belastungen des piezoelektrischen Materials im Ausgangsbereich verringert sein.

Durch das Verhältnis der Länge der längsten Kante zu der Länge der kürzesten Kante kann eine verbesserte Effizienz der Ozongenerierung erreicht werden. Insbesondere kann es durch diese Wahl des Aspektverhältnisses ermöglicht werden, die Bauteilgröße zu verringern und gleichzeitig die Effizienz der Ozongenerierung beizubehalten oder sogar zu verbessern.

Ein weiterer Aspekt der vorliegenden Erfindung betrifft einen Plasmagenerator, der den oben beschriebenen piezoelektrischen Transformator aufweist. Der Plasmagenerator kann insbesondere zur Erzeugung eines nichtthermischen Atmosphärendruck-Plasmas geeignet sein.

Im Folgenden wird die vorliegende Erfindung anhand der Figuren beschrieben.
- Figur 1: zeigt einen piezoelektrischen Transformator in perspektivischer Ansicht.
- Figur 2: zeigt die Ergebnisse einer Messung, bei der die Ozonproduktion für den in Figur 1 gezeigten piezoelektrischen Transformator mit einem Vergleichsbeispiel verglichen wird.
- Figur 3: zeigt die Messergebnisse einer Messung, wobei die Ozongenerierung pro Volumeneinheit betrachtet wird.

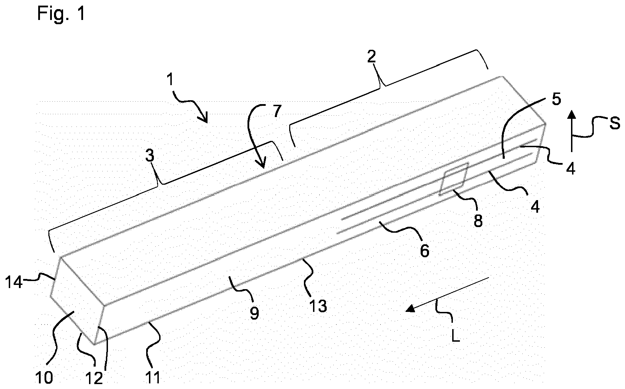

Figur 1 zeigt einen piezoelektrischen Transformator 1 in einer perspektivischen Ansicht. Der piezoelektrische Transformator 1 kann insbesondere in einer Vorrichtung zur Erzeugung von nichtthermischem Atmosphärendruck-Plasma eingesetzt werden.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf. Im Eingangsbereich 2 weist der piezoelektrische Transformator 1 Elektroden 4 auf, an die eine Wechselspannung angelegt werden kann. Die Elektroden 4 erstrecken sich in einer Längsrichtung L des piezoelektrischen Transformators 1. Die Elektroden 4 sind in einer Stapelrichtung S, die senkrecht zu der Längsrichtung L ist, abwechselnd mit einem piezoelektrischen Material 5 gestapelt. Das piezoelektrische Material 5 ist dabei in Stapelrichtung S polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Längsseite 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung S abwechselnd entweder mit der ersten Außenelektrode 8 oder der zweiten Außenelektrode elektrisch kontaktiert.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich ist in Längsrichtung L polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können. Im Ausgangsbereich ist das piezoelektrische Material zu einer einzigen monolithischen Schicht geformt, die vollständig in der Längsrichtung L polarisiert ist. Dabei weist das piezoelektrische Material im Ausgangsbereich nur eine einzige Polarisationsrichtung auf.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf. Die im Ausgangsbereich 3 erzeugte elektrische Spannung liegt somit zwischen der Stirnseite 10 und dem Ende der Elektroden 4 des Eingangsbereichs 2 an. An der ausgangsseitigen Stirnseite 10 liegt dabei eine Hochspannung an. Dabei entsteht auch zwischen der ausgangseitigen Stirnseite und einer Umgebung des piezoelektrischen Transformators eine hohe Potentialdifferenz, die ausreicht, um ein starkes elektrisches Feld zu erzeugen, dass ein Prozessgas ionisiert.

Auf diese Weise erzeugt der piezoelektrische Transformator 1 hohe elektrische Felder, die in der Lage sind, Gase oder Flüssigkeiten durch elektrische Anregung zu ionisieren. Dabei werden Atome oder Moleküle des jeweiligen Gases bzw. der jeweiligen Flüssigkeit ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle erforderlich ist.

Es kommt sowohl an den seitlichen Längskanten 11 als auch an den Kanten 12 der ausgangsseitigen Stirnseite 10 zu Zündungen von Plasma. Die Plasmazündungen entlang den seitlichen Längskanten 11 führen zu unerwünschten Rückkopplungen, bei denen hohe mechanische Spannungen in dem piezoelektrischen Material 9 des Ausgangsbereiches 3 erzeugt werden, die im Dauerbetrieb des piezoelektrischen Transformators 1 zu Rissen führen können, wodurch die Lebensdauer des piezoelektrischen Transformators 1 verringert wird. Um eine solche Beschädigung des piezoelektrischen Transformators 1 infolge der Plasmazündung zu vermeiden, ist der piezoelektrische Transformator 1 derart ausgestaltet, dass die Plasmazündung vor allem an der ausgangsseitigen Stirnseite 10 auftritt und die Plasmazündung an den seitlichen Längskanten 11 vermieden wird.

Bei dem piezoelektrischen Transformator 1 kommt es insbesondere an den Stellen zu einer Plasmazündung, an denen im Ausgangsbereich 3 des piezoelektrischen Transformators 1 ein Maximum des elektrischen Potentials auftritt. Im Folgenden wird genauer erläutert, wie der piezoelektrische Transformator 1 konstruiert ist, um die Plasmazündung an den seitlichen Längskanten 11 nach Möglichkeit zu vermeiden.

Der piezoelektrische Transformator 1 weist eine quaderförmige Form auf, wobei der piezoelektrische Transformator 1 eine längste Kante 13 und eine kürzeste Kante 14 aufweist. Die ausgangsseitige Stirnseite 10 weist eine rechteckige Form auf, wobei die kürzeste Kante der Stirnseite 10 die kürzeste Kante 14 des piezoelektrischen Transformators 1 darstellt. Die längste Kante 13 des piezoelektrischen Transformators 1 ist senkrecht zur ausgangsseitigen Stirnseite 10 und erstreckt sich von dem Eingangsbereich 2 zu dem Ausgangsbereich 3. Bei der längsten Kante 13 handelt es sich um eine seitliche Längskante 11.

Das Verhältnis der Länge der längsten Kante 13 zu der Länge der kürzesten Kante 14 wird als Aspektverhältnis bezeichnet. Es hat sich gezeigt, dass der piezoelektrische Transformator 1 Plasma insbesondere in verstärktem Maße an der ausgangsseitigen Stirnseite 10 erzeugt, wenn der piezoelektrische Transformator 1 derart konstruiert ist, dass sich ein Aspektverhältnis ≤ 20:1 ergibt.

Das Aspektverhältnis wirkt sich auf die Kapazität des Ausgangsbereiches 3 des piezoelektrischen Transformators 1 aus. Der Ort, an dem im Ausgangsbereich 3 ein Maximum eines elektrischen Potentials erreicht wird, verschiebt sich wiederum in Abhängigkeit von der Kapazität des Ausgangsbereichs 3. Die Ausgangskapazität nimmt mit kleiner werdendem Aspektverhältnis zu. Es konnte sowohl experimentell als auch theoretisch gezeigt werden, dass bei einem Aspektverhältnis von ≤ 20:1 eine hinreichend große Ausgangskapazität erreicht wird, bei der das Maximum des erzeugten Ausgangspotentials auf der ausgangsseitigen Stirnseite 10 liegt. Wird das Aspektverhältnis größer als 20:1 gewählt, nimmt die Ausgangskapazität ab und das Maximum des Ausgangspotentials verschiebt sich entlang der seitliche Längskanten 11 weg von der ausgangsseitigen Stirnseite 10 in eine Richtung hin zu dem Eingangsbereich 2. In diesem Fall kommt es zu unerwünschten Plasmazündungen entlang der Kanten 11.

In einem ersten Ausführungsbeispiel weist die längste Kante 13 eine Länge von 41 mm auf. Die Kanten 12 der ausgangsseitigen Stirnseite 10 weisen eine Länge von 6 mm und 3 mm auf. Dementsprechend ist die 3mm lange Kante der Stirnseite 10 die kürzeste Kante 14 des piezoelektrischen Transformators 1. Damit ergibt sich ein Aspektverhältnis von 13,667:1, d.h. ein vorteilhaftes Aspektverhältnis, das kleiner gleich 20:1 ist.

Bei einer experimentellen Untersuchung wurden zehn piezoelektrische Transformatoren 1 gemäß dem ersten Ausführungsbeispiel in einem Dauerbetrieb von 1000 Stunden betrachtet, wobei bei keinem der Transformatoren 1 im Ausgangsbereich 3 ein Riss erzeugt wurde und es zu dementsprechend keinem Ausfall von einem der piezoelektrischen Transformatoren 1 kam.

Gemäß einem zweiten Ausführungsbeispiel kann die längste Kante 13 kleiner als 35 mm sein. Beispielsweise kann der piezoelektrische Transformator 1 eine längste Kante 13 mit einer Länge von 30 mm aufweisen. Die Stirnseite 10 weist Kantenlängen von 3 mm und 2,4 mm aufweisen. Auch in diesem Fall ergibt sich das vorteilhafte Aspektverhältnis von ≤ 20:1. Insbesondere ergibt sich ein Aspektverhältnis von 12,5:1.

Die Resonanzfrequenz des piezoelektrischen Transformators 1 hängt von der Länge der längsten Kante 13 ab. Das zweite Ausführungsbeispiel führt zu einer Resonanzfrequenz von mehr als 100 kHz.

Piezoelektrische Transformatoren 1 mit einer Resonanzfrequenz von mehr als 100 kHz sind insbesondere für medizinische Anwendungen einsetzbar. Zu einer solchen medizinischen Anwendung zählt beispielsweise das Schneiden von Geweben mittels Plasmaschneiden. Dabei sollte das Reizen von Nerven vermieden werden. Die Ionenleitfähigkeit von Nerven nimmt bei Frequenzen ab 100 kHz signifikant ab. Dementsprechend eignen sich Plasmageneratoren, die mit Frequenzen von über 100 kHz arbeiten, besonders gut für das Plasmaschneiden von Gewebe. Der oben beschriebene piezoelektrische Transformator 1 gemäß dem zweiten Ausführungsbeispiel kann in einem solchen Plasmagenerator eingesetzt werden.

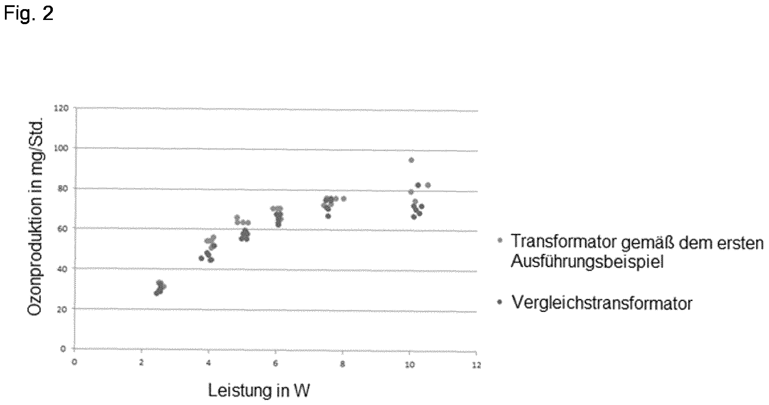

Figur 2 zeigt die Messergebnisse einer Vergleichsmessung, bei der ein piezoelektrischer Transformator 1 gemäß dem ersten Ausführungsbeispiel verglichen wurde mit einem Vergleichstransformator, der eine Länge von 71 mm und eine Stirnseite mit dem Querschnitt 6mm x 3 mm aufweist. In beiden Fällen wurde Luft als Prozessgas verwendet und von dem jeweiligen piezoelektrischen Transformator 1 ionisiert.

In Figur 2 ist auf der Abszissenachse die Leistung in W eingetragen, mit der der jeweilige piezoelektrische Transformator 1 betrieben wurde. Auf der Ordinatenachse ist die produzierte Menge an Ozon in mg/Stunde aufgetragen. Die in Figur 2 gezeigten Messergebnisse zeigen, dass kein signifikanter Unterschied in der Ozonproduktion zu finden ist. Insbesondere können mit dem piezoelektrischen Transformator 1, der das vorteilhafte Aspektverhältnis von ≤ 20:1 aufweist, eine im Wesentlichen identische Menge an Ozon bei gleicher Eingangsleistung produziert werden, wobei der piezoelektrischen Transformator 1 mit dem Aspektverhältnis ≤ 20:1 eine deutlich kürzere Länge als der Vergleichstransformator aufweist.

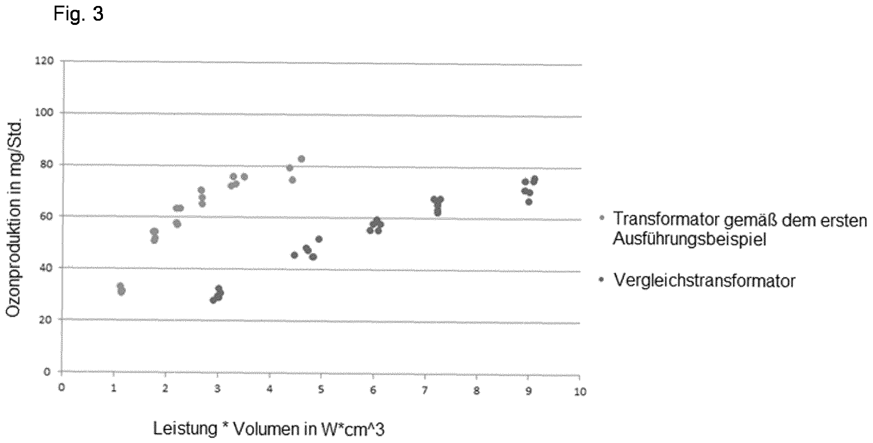

Figur 3 stellt ebenfalls einen Vergleich zwischen dem piezoelektrischen Transformator gemäß dem ersten Ausführungsbeispiel und dem Vergleichstransformator, der nicht das bevorzugte Aspektverhältnis von ≤ 20:1 aufweist, dar. Hierbei wird ein Produkt aus Eingangsleistung und Volumen des jeweiligen Transformators betrachtet. Auf der Abszissenachse ist das Produkt aus Eingangsleistung und Volumen in W x cm³ aufgetragen. Auf der Ordinatenachse ist wiederum die pro Stunde erzeugte Menge an Ozon in mg aufgetragen. Als Prozessgas wurde wiederum Luft verwendet. Es ist deutlich zu erkennen, dass der piezoelektrische Transformator 1 mit dem bevorzugten Aspektverhältnis pro Volumeneinheit eine größere Menge an Ozon produziert. Dementsprechend weist dieser piezoelektrische Transformator 1 eine höhere Effizienz der Ozongenerierung auf.

Diese experimentell beobachtete Verbesserung der Effizienz der Ozongenerierung an Luft infolge des vorteilhaften Aspektverhältnisses kann auch theoretisch erklärt werden. Die Effizienz der Ozongenerierung hängt von der Anpassung der Ausgangsimpedanz des piezoelektrischen Transformators 1 an die durch das Plasma erzeugte Impedanz sowie von der Steilheit der Flanken der Ausgangsspannung ab. Die Flankensteilheit der Ausgangsspannung hängt bei einer sinusförmigen Spannung im Wesentlichen von der Resonanzfrequenz ab. Dementsprechend weisen piezoelektrische Transformatoren 1, deren längste Seite 13 eine geringe Länge aufweist und die dementsprechend eine hohe Resonanzfrequenz aufweisen, steile Flanken auf, die sich wiederum positiv auf die Effizienz der Ozongenerierung auswirken.

Es konnte ferner gezeigt werden, dass das vorteilhafte Aspektverhältnis die Anpassung der Impedanz des piezoelektrischen Transformators 1 an eine von dem Plasma erzeugte Impedanz verbessert.

Sowohl die Längskanten 11 als auch die Kanten 12 der ausgangsseitigen Stirnseite des piezoelektrischen Transformators können abgerundet sein. Ist der Kurvenradius der abgerundeten Kanten hinreichend klein gewählt, beispielsweise kleiner als 0,5 mm, kann der piezoelektrische Transformator 1 näherungsweise als quaderförmig betrachtet werden.

Bei einigen Ausführungsbeispielen des piezoelektrischen Transformators 1 weist dieser im Ausgangsbereich 3 eine isolierende Schicht auf, die beispielsweise von einem Schrumpfschlauch gebildet wird. Die isolierende Schicht kann die ausgangseitige Stirnseite 10 freilassen und die übrigen Seitenflächen des Ausgangsbereichs 3 zumindest teilweise bedecken. Die isolierende Schicht soll unerwünschte Plasmazündungen entlang der seitliche Längskanten 11 verhindern und diese zu diesem Zweck abdecken. Da aufgrund des vorteilhaften Aspektverhältnisses keine Plasmazündungen entlang der seitlichen Längskanten 11 zu erwarten sind, kann der piezoelektrische Transformator 1 frei von der isolierenden Schicht im Ausgangsbereich 3 sein. In einem alternativen Ausführungsbeispiel kann eine solche isolierende Schicht vorgesehen werden, um die Isolierung des Ausgangsbereichs 3 weiter zu verbessern.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: erste Außenelektrode
- 9: piezoelektrisches Material
- 10: ausgangsseitige Stirnseite
- 11: seitliche Längskante
- 12: Kante der Stirnseite
- 13: längste Kante
- 14: kürzeste Kante
- L: Längsrichtung
- S: Stapelrichtung

## Patentansprüche

1. Verfahren zur Erzeugung eines Plasmas mit einem Plasmagenerator aufweisend einen piezoelektrischen Transformator (1),
aufweisend einen Eingangsbereich (2) und einen Ausgangsbereich (3),
wobei eine Wechselspannung an den Eingangsbereich (2) angelegt wird und der Eingangsbereich die angelegte Wechselspannung in eine mechanische Schwingung wandelt, wobei der Ausgangsbereich (3) die mechanische Schwingung in eine elektrische Spannung wandelt, und
wobei der piezoelektrische Transformator (1) ein Plasma an einer ausgangsseitigen Stirnseite (10) des piezoelektrischen Transformators (1) zündet
**dadurch gekennzeichnet,**
**dass** der piezoelektrische Transformator (1) eine längste Kante (13) und eine kürzeste Kante (14) aufweist, wobei die längste Kante (13) eine Länge aufweist, die maximal das Zwanzigfache der Länge der kürzesten Kante (14) beträgt.

2. Verfahren gemäß Anspruch 1,
wobei die längste Kante (13) eine Länge von weniger als 45 mm aufweist.

3. Verfahren gemäß einem der vorherigen Ansprüche,
wobei die längste Kante (13) eine Länge von weniger als 35 mm aufweist.

4. Verfahren gemäß einem der vorherigen Ansprüche,
wobei auf einer ersten Seitenfläche (6) des Eingangsbereichs (2) eine erste Außenelektrode (8) angeordnet ist,
wobei auf einer zweiten Seitenfläche (7) des Eingangsbereichs (2), die der ersten Seitenfläche (6) gegenüberliegt, eine zweite Außenelektrode angeordnet ist,
wobei der Eingangsbereich (2) in einer Stapelrichtung (S) übereinander gestapelte piezoelektrische Schichten (5) und Elektroden (4) aufweist, wobei die Elektroden (4) in der Stapelrichtung (S) abwechselnd entweder mit der ersten Außenelektrode (8) oder mit der zweiten Außenelektrode kontaktiert sind, und
wobei der Ausgangsbereich (3) eine monolithische piezoelektrische Schicht (9) aufweist.

5. Verfahren gemäß einem der vorherigen Ansprüche,
wobei die längste Kante (13) sich von dem Eingangsbereich (2) zu dem Ausgangsbereich (3) erstreckt.

6. Verfahren gemäß einem der vorherigen Ansprüche,
wobei die kürzeste Kante (14) senkrecht zur längsten Kante (13) ist.

7. Verfahren gemäß einem der vorherigen Ansprüche,
wobei der piezoelektrische Transformator (1) eine Resonanzfrequenz von mehr als 100 kHz aufweist.

8. Verfahren gemäß einem der vorherigen Ansprüche,
wobei die längste Kante (13) eine Länge aufweist, die maximal das Fünfzehnfache der Länge der kürzesten Kante (14) des piezoelektrischen Transformators (1) beträgt.

9. Verfahren gemäß Anspruch 1,
wobei die kürzeste Kante (14) eine Länge zwischen 10 mm und 1 mm aufweist.

10. Verfahren gemäß einem der vorangehenden Ansprüche,
wobei Luft als Prozessgas verwendet wird,
wobei durch das Verhältnis der Länge der längsten Kante (13) zu der Länge der kürzesten Kante (14) des piezoelektrischen Transformators (1) im Vergleich zu einem Vergleichstransformator, der nicht das bevorzugte Verhältnis der Länge der längsten Kante (13) zur Länge der kürzesten Kante (14) von ≤ 20:1 aufweist, bei gleichbleibender Eingangsleistung pro Volumeneinheit des piezoelektrischen Transformators eine verbesserte Effizienz der Ozongenerierung erreicht wird.

11. Verfahren gemäß einem der vorangehenden Ansprüche,
wobei der piezoelektrische Transformator (1) abgerundete Kanten aufweist, die mit einem Radius von ≤ 0,5 mm abgerundet sind.

12. Verfahren gemäß einem der vorangehenden Ansprüche,
wobei eine Impedanz des piezoelektrischen Transformators (1) an eine von dem Plasma erzeugte Impedanz angepasst ist.

13. Verfahren gemäß einem der vorangehenden Ansprüche,
wobei durch das Wandeln der mechanischen Schwingung in die elektrische Spannung im Ausgangsbereich (3) entsteht zwischen der ausgangseitigen Stirnseite (10) und einer Umgebung des piezoelektrischen Transformators (1) eine hohe Potentialdifferenz, die ausreicht, um ein starkes elektrisches Feld zu erzeugen, dass ein Prozessgas ionisiert.

14. Verfahren gemäß einem der vorangehenden Ansprüche,
wobei im Ausgangsbereich (3) ein Maximum eines elektrischen Potentials auf der ausgangsseitigen Stirnseite (10) liegt.

15. Medizinisches Gerät aufweisend,
einen Plasmagenerator aufweisend einen piezoelektrischen Transformator (1) zur Erzeugung von Plasma, aufweisend einen Eingangsbereich (2) und einen Ausgangsbereich (3),
wobei der Eingangsbereich (2) dazu ausgestaltet ist, eine angelegte Wechselspannung in eine mechanische Schwingung zu wandeln,
wobei der Ausgangsbereich (3) dazu ausgestaltet ist, eine mechanische Schwingung in eine elektrische Spannung zu wandeln, und
wobei der piezoelektrische Transformator (1) eine längste Kante (13) und eine kürzeste Kante (14) aufweist, wobei die längste Kante (13) eine Länge aufweist, die maximal das Zwanzigfache der Länge der kürzesten Kante (14) beträgt,
wobei der piezoelektrische Transformator (1) dazu ausgestaltet ist, ein Plasma an einer ausgangsseitigen Stirnseite (10) des piezoelektrischen Transformators (1) zu zünden.

16. Medizinisches Gerät gemäß dem der vorangehenden Anspruch,
wobei das medizinische Gerät für Plasmaschneiden von Gewebe ausgestaltet ist.

## Claims

1. Method for generating a plasma using a plasma generator comprising a piezoelectric transformer (1), comprising an input region (2) and an output region (3), wherein an AC voltage is applied to the input region (2) and the input region converts the applied AC voltage into a mechanical oscillation, wherein the output region (3) converts the mechanical oscillation into an electrical voltage, and
wherein the piezoelectric transformer (1) ignites a plasma on an output-side end side (10) of the piezoelectric transformer (1),
**characterized in that**
the piezoelectric transformer (1) comprises a longest edge (13) and a shortest edge (14), wherein the longest edge (13) comprises a length that is a maximum of twenty times the length of the shortest edge (14).

2. Method according to Claim 1,
wherein the longest edge (13) comprises a length of less than 45 mm.

3. Method according to either of the preceding claims, wherein the longest edge (13) comprises a length of less than 35 mm.

4. Method according to any of the preceding claims, wherein a first external electrode (8) is arranged on a first side surface (6) of the input region (2),
wherein a second external electrode is arranged on a second side surface (7) of the input region (2), said second side surface being situated opposite the first side surface (6),
wherein the input region (2) comprises piezoelectric layers (5) and electrodes (4) stacked one above another in a stacking direction (S), wherein the electrodes (4) are contacted either with the first external electrode (8) or with the second external electrode alternately in the stacking direction (S), and
wherein the output region (3) comprises a monolithic piezoelectric layer (9).

5. Method according to any of the preceding claims, wherein the longest edge (13) extends from the input region (2) to the output region (3).

6. Method according to any of the preceding claims, wherein the shortest edge (14) is perpendicular to the longest edge (13).

7. Method according to any of the preceding claims, wherein the piezoelectric transformer (1) has a resonant frequency of more than 100 kHz.

8. Method according to any of the preceding claims, wherein the longest edge (13) comprises a length that is a maximum of fifteen times the length of the shortest edge (14) of the piezoelectric transformer (1).

9. Method according to Claim 1,
wherein the shortest edge (14) comprises a length of between 10 mm and 1 mm.

10. Method according to any of the preceding claims, wherein air is used as process gas,
wherein, with the input power remaining the same per unit volume of the piezoelectric transformer, an improved ozone generation efficiency is achieved by means of the ratio of the length of the longest edge (13) to the length of the shortest edge (14) of the piezoelectric transformer (1) compared to a comparative transformer that does not comprise the preferred ratio of the length of the longest edge (13) to the length of the shortest edge (14) of ≤ 20:1.

11. Method according to any of the preceding claims, wherein the piezoelectric transformer (1) comprises rounded edges, which are rounded with a radius of ≤ 0.5 mm.

12. Method according to any of the preceding claims, wherein an impedance of the piezoelectric transformer (1) is adjusted to an impedance generated by the plasma.

13. Method according to any of the preceding claims, wherein converting the mechanical oscillation into the electrical voltage in the output region (3) produces a high potential difference between the output-side end side (10) and an environment of the piezoelectric transformer (1), said potential difference being sufficient to generate a strong electric field that ionizes a process gas.

14. Method according to any of the preceding claims, wherein in the output region (3) a maximum of an electrical potential is present on the output-side end side (10).

15. Medical device comprising
a plasma generator comprising a piezoelectric transformer (1) for generating plasma,
comprising an input region (2) and an output region (3), wherein the input region (2) is configured to convert an applied AC voltage into a mechanical oscillation, wherein the output region (3) is configured to convert a mechanical oscillation into an electrical voltage, and wherein the piezoelectric transformer (1) comprises a longest edge (13) and a shortest edge (14), wherein the longest edge (13) comprises a length that is a maximum of twenty times the length of the shortest edge (14), wherein the piezoelectric transformer (1) is configured to ignite a plasma on an output-side end side (10) of the piezoelectric transformer (1).

16. Medical device according to the preceding claim, wherein the medical device is configured for plasma cutting of tissue.

## Revendications

1. Procédé pour générer un plasma avec un générateur de plasma comprenant un transformateur piézoélectrique (1),
comprenant une zone d'entrée (2) et une zone de sortie (3),
une tension alternative étant appliquée à la zone d'entrée (2) et la zone d'entrée convertissant la tension alternative appliquée en une oscillation mécanique,
la zone de sortie (3) convertissant l'oscillation mécanique en une tension électrique, et
le transformateur piézoélectrique (1) allumant un plasma au niveau d'un côté frontal (10) côté sortie du transformateur piézoélectrique (1),
**caractérisé en ce que**
le transformateur piézoélectrique (1) possède une arête la plus longue (13) et une arête la plus courte (14), l'arête la plus longue (13) présentant une longueur qui est au maximum égale à vingt fois la longueur de l'arête la plus courte (14).

2. Procédé selon la revendication 1, l'arête la plus longue (13) présentant une longueur inférieure à 45 mm.

3. Procédé selon l'une des revendications précédentes, l'arête la plus longue (13) présentant une longueur inférieure à 35 mm.

4. Procédé selon l'une des revendications précédentes, une première électrode externe (8) étant disposée sur une première surface latérale (6) de la zone d'entrée (2), une deuxième électrode externe étant disposée sur une deuxième surface latérale (7) de la zone d'entrée (2), qui se trouve à l'opposé de la première surface latérale (6),
la zone d'entrée (2) possédant des couches piézoélectriques (5) et des électrodes (4) empilées les unes au-dessus des autres dans une direction d'empilement (S), les électrodes (4) étant, dans la direction d'empilement (S), mises en contact en alternance soit avec la première électrode externe (8), soit avec la deuxième électrode externe, et
la zone de sortie (3) possédant une couche piézoélectrique (9) monolithique.

5. Procédé selon l'une des revendications précédentes, l'arête la plus longue (13) s'étendant de la zone d'entrée (2) à la zone de sortie (3).

6. Procédé selon l'une des revendications précédentes, l'arête la plus courte (14) s'étendant perpendiculairement à l'arête la plus longue (13).

7. Procédé selon l'une des revendications précédentes, le transformateur piézoélectrique (1) présentant une fréquence de résonance supérieure à 100 kHz.

8. Procédé selon l'une des revendications précédentes, l'arête la plus longue (13) présentant une longueur qui est au maximum égale à quinze fois la longueur de l'arête la plus courte (14) du transformateur piézoélectrique (1).

9. Procédé selon la revendication 1, l'arête la plus courte (14) présentant une longueur entre 10 mm et 1 mm.

10. Procédé selon l'une des revendications précédentes, de l'air étant utilisé comme gaz de processus, un rendement amélioré de la génération d'ozone étant obtenu grâce au rapport de la longueur de l'arête la plus longue (13) sur la longueur de l'arête la plus courte (14) du transformateur piézoélectrique (1) en comparaison d'un transformateur de comparaison, qui ne présente pas le rapport préférentiel ≤ 20:1 de la longueur de l'arête la plus longue (13) sur la longueur de l'arête la plus courte (14), avec une puissance d'entrée constante par unité de volume du transformateur piézoélectrique.

11. Procédé selon l'une des revendications précédentes, le transformateur piézoélectrique (1) possédant des arêtes arrondies, qui sont arrondies avec un rayon ≤ 0,5 mm.

12. Procédé selon l'une des revendications précédentes, une impédance du transformateur piézoélectrique (1) étant adaptée à une impédance générée par le plasma.

13. Procédé selon l'une des revendications précédentes, la conversion de l'oscillation mécanique en la tension électrique dans la zone de sortie (3) produisant, entre le côté frontal (10) côté sortie et un environnement du transformateur piézoélectrique (1), une différence de potentiel élevée qui est suffisante pour générer un champ électrique puissant, lequel ionise un gaz de processus.

14. Procédé selon l'une des revendications précédentes, dans la zone de sortie (3), un maximum d'un potentiel électrique se trouvant sur le côté frontal (10) côté sortie.

15. Appareil médical comprenant
un générateur de plasma comprenant un transformateur piézoélectrique (1) destiné à générer du plasma, comprenant une zone d'entrée (2) et une zone de sortie (3) ,
la zone d'entrée (2) étant configurée pour convertir une tension alternative appliquée en une oscillation mécanique,
la zone de sortie (3) étant configurée pour convertir une oscillation mécanique en une tension électrique, et
le transformateur piézoélectrique (1) possédant une arête la plus longue (13) et une arête la plus courte (14), l'arête la plus longue (13) présentant une longueur qui est au maximum égale à vingt fois la longueur de l'arête la plus courte (14),
le transformateur piézoélectrique (1) étant configuré pour allumer un plasma au niveau d'un côté frontal (10) côté sortie du transformateur piézoélectrique (1).

16. Appareil médical selon la revendication précédente, l'appareil médical étant configuré pour la découpe au plasma de tissus.
